(19) Europäisches Patentamt / European Patent Office / Office européen des brevets

(11) **EP 4 407 328 A1**

(12) **EUROPEAN PATENT APPLICATION**

(43) Date of publication:
**31.07.2024 Bulletin 2024/31**

(21) Application number: **23153044.5**

(22) Date of filing: **24.01.2023**

(51) International Patent Classification (IPC):
**G01R 31/367** *(2019.01)*   **G01R 31/396** *(2019.01)*
**H02J 7/00** *(2006.01)*

(52) Cooperative Patent Classification (CPC):
**G01R 31/396; G01R 31/367; H02J 7/00302;**
**H02J 7/00306; H02J 7/0048;** G01R 31/374

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(71) Applicant: **Rimac Technology LLC**
**10431 Sveta Nedelja (HR)**

(72) Inventors:
• **Fedorova, Anna Alekseevna**
  **Zagreb (HR)**
• **Bralic, Ivan**
  **Dubrovnik (HR)**

(74) Representative: **Hoffmann Eitle**
**Patent- und Rechtsanwälte PartmbB**
**Arabellastraße 30**
**81925 München (DE)**

(54) **ESTIMATING A BATTERY STATE OF CHARGE UNDER NON-UNIFORM TEMPERATURE CONDITIONS**

(57)    A method for estimating a battery state of charge, SoC, of a battery comprising a plurality of battery cells, the method comprising the steps of: determining a battery cell SoC for each of the plurality of battery cells; and determining the battery SoC using a weighted sum of the plurality of battery cell SoC, wherein the weight corresponding to each battery cell SoC is determined based on at least a temperature of the battery cell and a SoC of the battery cell.

FIG. 2

EP 4 407 328 A1

## EP 4 407 328 A1

**Description**

Technical field

The present invention relates to estimating a battery state of charge, in particular to estimating a battery state of charge of a battery comprising a plurality of battery cells. Corresponding implementations relate to a method for estimating a battery state of charge, a module for estimating a battery state of charge and a system comprising the module for estimating a battery state of charge and the battery. Specifically, the present invention relates to estimating a battery state of charge under non-uniform temperature conditions. The present invention can, for example, find an application in the context of battery charging and discharging, as e.g., common in energy storages, electric vehicles, consumer products, etc.

Technical background

In the vast field of battery management, a common quantity to be determined (estimated) precisely, in particular during charging as well as discharging of a battery, is the state of charge (SoC). As state of charge one commonly understands the level of charge of an electric battery relative to its capacity and it is expressed in percentage points, wherein 0% corresponds to 'empty' (an empty battery) and 100% corresponds to 'full' (a full battery). The estimation of the state of charge of a battery during a charging (or discharging) process is in particular important to avoid overcharging (or overdischarging), i.e., charging (or discharging) the battery with an excessive current, that is a current higher than the battery can withstand. This may in particular happen when the state of charge is underestimated as in this case more current is provided to the battery than the battery can absorb without difficulties. Negative effects of overcharging typically range from the battery heating up to permanent damage of the battery reducing its functionalities and may even lead up to the battery exploding; similarly, also overdischarging may lead to permanent damage of the battery and/or reducing its functionalities.

Further, while determining the state of charge of a single battery cell is already a non-trivial task due to the battery cell being a complex electrochemical energy source, the determination of the state of charge of a battery comprising a plurality of battery cells adds another level of complexity due to each battery cell having a different state of charge. This is particular because the different battery cells may have different temperatures due to their different position within the battery pack or battery module: battery cells closer the center of the battery may be subject to more heat while battery cells in closer proximity to a border or wall of the battery pack or batter module may be subject to less heat. Further, also the position and flow of a coolant may have an influence on this.

A further aspect that may be taken into account is that battery cells change their properties over time and with repeated use: they provide less energy and power after long usage periods. This process, called ageing of the battery cell, may be taken into account as well when accurately estimating the state of charge.

However, as the battery is charged/discharged as a whole, not by charging/discharging each cell individually, a precise estimation of the battery as a whole is important for the charging/discharging process to work without endangering the battery.

In view of these considerations, a straightforward approach could be to simply consider the average of the state of charge of each battery cell. However, such an estimation of the state of charge of the battery fails to account at least for the non-uniform distribution temperature of the state of charge of the plurality of battery cells and thus may lead to an underestimation of the state of charge of the battery, thereby risking overcharging the battery. Clearly, also other aspects such as age of the battery cells may have an influence and thus may be taken into account for a more accurate estimation of the state of charge of a battery.

In view thereof, there is a need for a method of estimating a battery state of charge that takes into account the above complexities of battery cells and provides a more accurate estimate of the state of charge of the battery.

Summary

The above problems, among others, are solved by the subject-matter of the independent claims. Preferred embodiments are given by the subject-matter of the dependent claims.

According to an embodiment of the present invention, there is provided a method for estimating a battery state of charge, SoC, of a battery comprising a plurality of battery cells, the method comprising the steps of: determining a battery cell SoC for each of the plurality of battery cells; and determining the battery SoC using a weighted sum of the plurality of battery cell SoC, wherein the weight corresponding to each battery cell SoC is determined based on at least a temperature of the battery cell and a SoC of the battery cell.

According to a further embodiment of the present invention, there is provided a method for estimating a battery state of charge, SoC, of a battery comprising a plurality of battery cells, the method comprising the steps of: determining

2

a minimum battery cell SoC and a maximum battery cell SoC among the plurality of battery cells; and determining the battery SoC using a weighted sum of the minimum battery cell SoC and the maximum battery cell SoC.

According to a further embodiment of the present invention, there is provided a module provided in an energy storage for estimating a battery state of charge, SoC, of a battery comprising a plurality of battery cells, the module being configured to perform the steps of: determining a battery cell SoC for each of the plurality of battery cells; and determining the battery SoC using a weighted sum of the plurality of battery cell SoC, wherein the weight corresponding to each battery cell SoC is determined based on at least a temperature of the battery cell and a SoC of the battery cell.

According to a further embodiment of the present invention, there is provided a module provided in an energy storage for estimating a battery state of charge, SoC, of a battery comprising a plurality of battery cells, the module being configured to perform the steps of: determining a minimum battery cell SoC and a maximum battery cell SoC among the plurality of battery cells; and determining the battery SoC using a weighted sum of the minimum battery cell SoC and the maximum battery cell SoC.

According to a further embodiment of the present invention, there is provided an energy storage system comprising a module according to an embodiment of the present invention and the battery.

The present invention can provide a technique for a precise estimation of a state of charge of a battery, in particular a battery comprising a plurality of battery cells, thereby improving protection against overcharging/overdischarging.

Further, the technique presented provides a smooth estimation of the state of charge of a battery in the sense that during charging/discharging of a battery, the estimated state of charge does not change abruptly.

Moreover, the improved estimation of the state of charge of the battery is computationally simple, that is, does not impose particular requirements and thus can be implemented easily, especially can be implemented in embedded systems such as in an electric vehicle.

The present invention can moreover provide a technique for a precise estimation of a state of charge of a battery that prevents overcharging/overdischarging by considering safety limits in the estimation.

Brief description of the drawings

Embodiments of the present invention, which are presented for better understanding the inventive concepts, but which are not to be seen as limiting the invention, will now be described with reference to the figures in which:

Figure 1     shows an exemplary battery related to the present invention;

Figure 2     shows a flowchart of a method according to an embodiment according to the present invention;

Figure 3     shows a flowchart of a method according to a further embodiment of the present invention; and

Figure 4     shows a schematic view of a module according to an embodiment of the present invention.

Detailed description

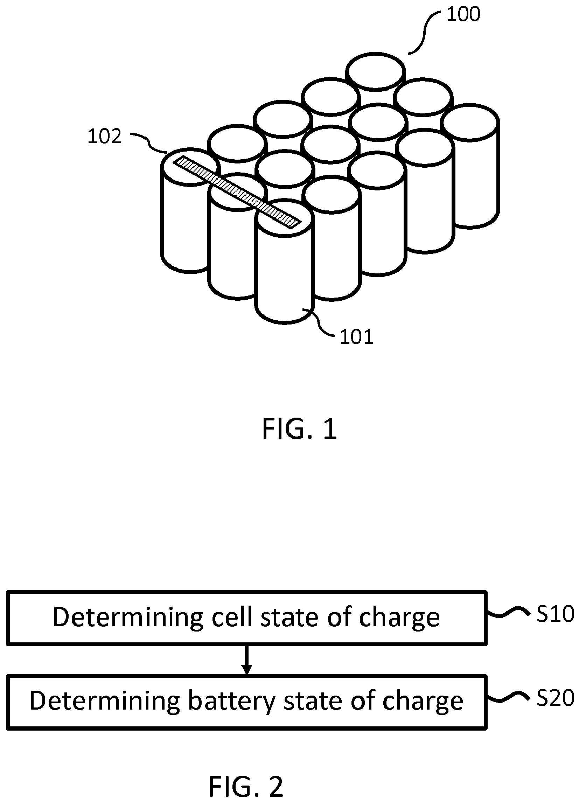

Figure 1 shows an exemplary battery related to the present invention. Specifically, Figure 1 shows a battery 100 comprising a plurality of battery cells (or simply cells) 101. In this context, the term "battery pack" or "battery module" may be used for the battery 100 as well. The battery cells 101 may be arranged as battery strings (or simply strings) 102 as indicated by the bar on the top of the first three battery cells 101 in Figure 1. Battery cells 101 can be arranged in series or in parallel with respect to each other. Similarly, battery strings 102 can be arranged in series or in parallel with respect to each other. This may be in particular be motivated to achieve a predetermined energy and/or predetermined power of the battery 100. Typical examples for the battery 100 include lithium-ion batteries of various types, however, the present invention is not limited thereto.

Moreover, an alternative, inverse form of the state of charge is depth of discharge (DoD) which is typically used when discussing the lifetime of a battery after repeated use. In this case, 100% corresponds to an empty battery and 0% to a fully charged battery. While the present disclosure mostly relates to scenarios in which the state of charge is used, it is understood that the concepts disclosed herein can be applied correspondingly to scenarios in which the depth of discharge is the figure of merit of interest.

Figure 2 shows a flowchart of a method according to an embodiment of the present invention. Specifically, the flowchart of Figure 2 shows a method for estimating a battery state of charge (SoC) of a battery 100 comprising a plurality of battery cells 101, the method comprising the steps of: determining a battery cell SoC for each of the plurality of battery cells 101 (step S20); and determining the battery SoC using a weighted sum of the plurality of battery cell SoC, wherein the weight corresponding to each battery cell SoC is determined based on at least a temperature of the battery cell 101 and a SoC of the battery cell 101.

By including, on top of the state of charge, also the temperature of the battery cell into the determination of its weight, the determination of the state of charge of the battery may have various advantages. Among them, making the state of charge temperature-dependent allows for non-uniform temperature profiles of the battery to be taken into account and thus cells closer to overcharging/overdischarging may have a higher impact in the overall state of charge determination, thereby reducing the risk for overcharging/overdischarging.

The weight corresponding to each battery cell SoC may be determined based on at least one of a temperature of the battery cell 101, a SoC of the battery cell 101 and/or an age of the battery cell 101. Including the age of the battery cell may further improve the accuracy of the state of charge determination since also the age may have an impact on the battery behavior and thus on the state of charge.

The temperature of each battery cell 101 may be obtained based on calculations of the battery temperature distribution taking into account the spatial arrangement of the battery cells 101 within the battery 100. These calculations of the battery temperature distribution may be performed in advance. Moreover, these calculations may be 3D temperature computational calculations, in particular computational fluid dynamics calculations. Such calculations may be based on partial differential equations modelling the battery and its temperature behavior. An example of such calculations can be found in Smyshlyaev, Andrey et al. "PDE model for thermal dynamics of a large Li-ion battery pack", Proceedings of the 2011 American Control Conference, IEEE, 2011. Such calculations as a founding element of the determination of the weights may improve the accuracy of the determination of the state of charge as they may improve the accuracy of the temperature distribution within the battery and thus may allow to more accurately determine the impact of each battery cell and its state of charge to the overall state of charge of the battery.

While it is generally possible to measure the temperature of a battery, the sensors typically measure the temperature of the group of cells, not of each cell of the battery and moreover the position of the sense typically leads to noise such that the accuracy of a temperature acquired by sensors alone is insufficient for a precise assessment of the state of the battery.

Further, the weight corresponding to each battery cell may be positively correlated, or in more general terms simply correlated, to the temperature of the battery cell and/or to the state of charge of the battery cell. The first part of this may be understood in the sense that if the temperature of a battery cell increases (while keeping the remaining parameters constant), the weight corresponding to this battery cell increases as well. Similarly, the second part may be understood in the sense that if the state of the battery cell increases (while keeping the remaining parameters constant), the weight corresponding to this battery cell increases as well.

This can be understood in the following illustrative way for the case of overcharging: If a battery cell has a higher state of charge, it is closer to being fully charged and thus, following established knowledge about charging battery cells, has to be charged with less current/voltage to avoid overcharging. Accordingly, correlating positively the state of charge of a battery with its weight in the overall state of charge of the battery puts an emphasis on these battery cells already close to overcharging.

Similarly, a battery cell at a higher temperature may be more prone to overcharging as one of the effects of overcharging is an increased temperature of the battery cell. Thus, a battery cell having a higher temperature may be closer to overcharging and thus emphasis should be put on battery cells with higher temperatures to avoid overcharging.

Further, the battery cell SoC for each of the plurality of battery cells may be determined using at least one of a Kalman filter and/or Coulomb counting, which are two among a plurality of methods available for determining the state of charge of a battery cell. Here, Coulomb counting refers to the concept of measuring the discharge/charge of the battery, i.e., the current flowing out of the battery/the current flowing into the battery, at every time step and determining the state of charge by summing up/integrating the discharge/charge. Further, using a Kalman filter refers to using an equivalent circuit model of the battery cell to determine the state of charge of the battery, wherein the Kalman filter is used to adjust the accuracy of the determination via the equivalent circuit model. Clearly, the Kalman filter may be replaced by an alternative feedback-type or may not be used at all. In other words, standard methods for determining the state of charge of each of the plurality of the battery cells may be applied. In particular, it is to be understood that the determination of the state of charge of the battery cell is not limited to a particular method.

In the following, the above will be discussed in a specific example of charging a battery to illustrate the concepts discussed herein. The considerations made in this example can be applied correspondingly to a scenario of discharging a battery. In this example, we assume a battery having N battery cells. According, the state of charge of the battery, **SOC,** can be expressed as a function of the state of charge of the induvial battery cells, **SOC$_i$** as

$$SOC_{low} \leq SOC = \sum_{i=1}^{N} a_i \cdot SOC_i \leq SOC_{up}$$

wherein **SOC$_{low}$** and **SOC$_{up}$** refer to lower and upper safety limit of the state of charge that should be respected in any scenario.

In a first step, the temperature distribution within the battery is calculated in line with the above discussion.

In a next step, based on the temperature and the state of charge of the battery cell, its weight has to be determined. This step may be performed online and not offline, that is, during the performance of the method in a system and not as part of the preparatory part of the method. To this end, the above discussion on the influence of temperature and state of charge value of a battery cell on its charging time and thus its overcharging potential may be used: The higher the state of charge of a battery cell, the faster it will be charged full (assuming all other parameters remaining constant). Similarly, the higher the temperature of the battery cell, the faster it will be charged full (assuming all other parameters remaining constant). Accordingly, a function **F(T$_i$,SOC$_i$)** may be built such that it implements the above considerations and may for example map a temperature and a state of charge of a battery cell into a time required to fully charge or fully discharge the battery cell. This function may be based on or interpolated from experimental and/or empirical data and/or may be based on the above discussed calculations as well. For example, time values for fully charging and/or fully discharging the battery are obtained and the function **F(T$_i$,SOC$_i$)** is derived from this. This function may be a polynomial or any other function that is appropriate to represent the obtained data.

As in this case a smaller value of **F (T$_i$,SOC$_i$)** corresponds to a battery cell closer to being fully charged or fully discharged, thus closer to being overcharged or overdischarged, the coefficient **a$_i$** should be inverse proportional to **F (T$_i$,SOC$_i$),** for example, **a$_i$~F$^{-1}$(T$_i$,SOC$_i$).**

Further, the coefficients a$_i$ should all be in the interval **$0 \leq a_i \leq 1$** and the sum of all coefficients should be equal to 1, $\sum_{i=1}^{N} a_i = 1$. Accordingly, the coefficients may be set to be

$$a_i = \frac{F^{-1}(T_i, SOC_i)}{\sum_{i=1}^{N} F^{-1}(T_i, SOC_i)}.$$

While an implementation in which the function **F(T$_i$,SOC$_i$)** is directly evaluated may have its advantages as it allows a precise determination of the coefficients, for many applications, a look up table using discretized values may be sufficient. In this case, break points for both, temperature and state of charge have to be defined. In this example, the breakpoints for the temperature will be (in degrees Celsius): T$_1$ =-35, T$_2$ =-25, T$_3$ =-15, T$_4$ =-10, T$_5$ = 0, T$_6$ = 15, T$_7$ = 25, T$_8$ = 35, **T$_9$ = 45, T$_{10}$ = 55, T$_{11}$ = 65,** and **T$_{12}$ = 75.** The breakpoints for the state of charge will be (in percent) : **SOC$_0$ = 0, SOC$_1$ = 5, SOC$_2$ = 10, SOC$_3$ = 15, ... SOC$_{19}$ = 95,** and **SOC$_{20}$ = 100.** Clearly, a different choice of breakpoints may be made, in particular depending on the specific case.

Using these breakpoints, the function **F(T$_i$,SOC$_i$)** will be replaced by a discrete value t$_{jk}$ of the look up table, where the indices **j** and **k** indicate the breakpoints. More specifically, **F(T$_i$ =- 15°C,SOC$_i$ = 20%)** corresponds to **t$_{34}$** in the above example.

In the case of using discretized values, the above formula for the coefficients **a$_i$** takes the form

$$a_i = \frac{t_i^{-1}}{\sum_i t_i^{-1}},$$

where the indices **j** and **k** of **t$_{jk}$** indicating the breakpoints of temperature and state of charge are fused into the single index of the battery cell.

The use of a look up table may in particular be useful if it is preferred to use the storing resources to store the values of the look up table instead of computing resource to evaluate the function each time that the state of charge has to be determined.

Let us now consider a specific example of a battery comprising three battery cells with the following temperature and state of charge values:

| Cell | Temperature | State of charge |
|------|-------------|-----------------|
| #1 | 0 °C | 80% |
| #2 | 15 °C | 55% |
| #3 | 25 °C | 70% |

The values for the function $F(T_i, SOC_i)$, or rather the discrete values $t_{jk}$ are taken to be the following:

|           | T=0°C  | T=15°C | T=25°C |
|-----------|--------|--------|--------|
| SOC=55%   | 3000s  | 2500s  | 1800s  |
| SOC=70%   | 2000s  | 1500s  | 700s   |
| SOC=80%   | 1000s  | 750s   | 500s   |

The above discussed general trend that a higher state of charge and/or a higher temperature means a shorter (charging) time and smaller value of $F(T_i, SOC_i)/t_{jk}$ can be observed herein.

Accordingly, the coefficients for the cells #1 to #3 can be determined as

$$a_1 = \frac{t_1^{-1}}{\sum_i t_i^{-1}} = \frac{1000^{-1}}{1000^{-1} + 2500^{-1} + 700^{-1}} = 0.3535,$$

$$a_2 = \frac{t_2^{-1}}{\sum_i t_i^{-1}} = \frac{2500^{-1}}{1000^{-1} + 2500^{-1} + 700^{-1}} = 0.1414,$$

$$a_3 = \frac{t_3^{-1}}{\sum_i t_i^{-1}} = \frac{700^{-1}}{1000^{-1} + 2500^{-1} + 700^{-1}} = 0.5051.$$

By construction, the condition $\sum_{i=1}^{N} a_i = 0.3535 + 0.1414 + 0.5051 = 1$ is fulfilled. Finally, the state of charge of the battery is

$$SOC = \sum_{i=1}^{N} a_i \cdot SOC_i = a_1 \cdot SOC_1 + a_2 \cdot SOC_2 + a_3 \cdot SOC_3$$

$$= 0.3535 \cdot 80\% + 0.1414 \cdot 55\% + 0.5051 \cdot 70\% = 71.414\%$$

In particular when comparing this value with a state of charge estimation that simply takes the average of the state of charge values of the battery cell, which amounts to an state of charge of the battery of **(80% + 55% + 70%)/3 = 68.3%,** one can see that while the simple average lies below the state of charge of battery cell #3, which has a high state of charge and a high temperature and thus is closer to overcharging, the state of charge estimation according to this example of the present invention is given more weight to this battery cell #3, resulting in a higher battery state of charge and thus also protects battery cell #3 (in addition to the other battery cells #1 and #2) from overcharging.

Moreover, it is clear that the state of charge of the battery determined using the method according to the present invention during a charging/discharging process is a smooth curve, i.e., there are no abrupt changes in the determined values. This is in particular advantageous over methods in which maximum or minimum values of the battery cell state of charge are used to determine the state of charge of the battery.

In addition, it is clear that the proposed method is not limited to merely including the state of charge and the temperature of the battery cells, but can easily extended to other relevant parameters such as the age of the battery cell by simply replacing/extending the function $F(T_i, SOC_i)$ to a function such as $F(T_i, SOC_i, Age_i)$ or the like.

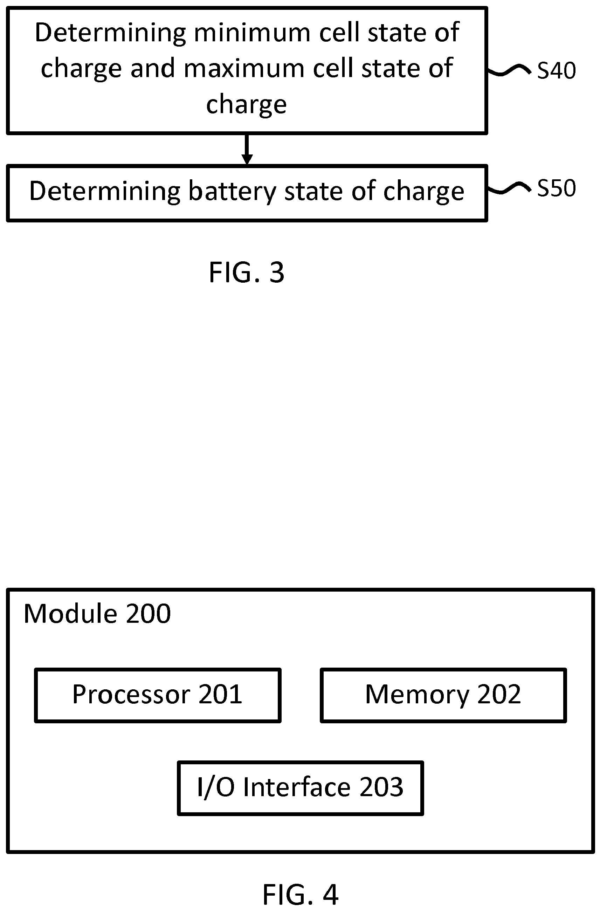

Figure 3 shows a flowchart of a method according to a further embodiment of the present invention. Specifically, the flowchart of Figure 3 shows a method for estimating a battery state of charge, SoC, of a battery comprising a plurality of battery cells, the method comprising the steps of: determining a minimum battery cell SoC and a maximum battery cell SoC among the plurality of battery cells; and determining the battery SoC using a weighted sum of the minimum battery cell SoC and the maximum battery cell SoC.

In other words, in this method the determination of the state of charge of the battery is performed in a simpler manner comparing to the method discussed in connection with Figure 2 as it merely relies on the minimum and maximum value of the state of charge of the battery cells and thus can be computationally more efficient, also compared to calculating the state of charge of the battery as the average of the state of charge values of the battery cells. Thus, this method may be used in cases in which the temperature distribution is (sufficiently) uniform such that a more complex estimation of the state of charge using the temperature distribution is not required to provide an accurate estimate.

Further, in this embodiment, the weight of the minimum battery cell SoC may be correlated to a difference between the minimum battery cell SoC and a lower limit of the battery cell SoC, and the weight of the maximum battery cell SoC is correlated to a difference between the maximum battery cell SoC and an upper limit of the battery cell SoC.

In terms of formulas, this can be understood/implemented as follows: The state of charge of the battery is a linear combination of the minimum battery cell state of charge and the maximum state of charge

$$SOC = c_{min} \cdot SOC_{min} + c_{max} \cdot SOC_{max}$$

where $c_{min} + c_{max} = 1$ is the normalization condition.

In case that the weight of the minimum battery cell SoC is correlated to a difference between the minimum battery cell SoC and a lower limit of the battery cell SoC, this can be understood as

$$c_{min} \sim \Delta_{up},$$

where

$$\Delta_{up} = |SOC_{max} - SOC_{up}|.$$

Similarly, the circumstance that the weight of the maximum battery cell SoC is correlated to a difference between the maximum battery cell SoC and an upper limit of the battery cell SoC can be understood as

$$c_{max} \sim \Delta_{low},$$

where

$$\Delta_{low} = |SOC_{min} - SOC_{low}|.$$

As discussed above, $SOC_{low}$ and $SOC_{up}$ refer to the lower and upper safety limit of the state of charge that should be respected in any scenario.

In view of the normalization condition, this then leads to

$$c_{min} = \frac{\Delta_{up}}{\Delta_{up} + \Delta_{low}}$$

and

$$c_{max} = \frac{\Delta_{low}}{\Delta_{up} + \Delta_{low}}$$

This approach thus takes into account the spread of extreme state of charge values and the proximity to the safety values. Compared to a conventional method of taking simply the average of the state of charge values of the battery cells, this approach is able to detect when a single battery cell approaches the safety values, which may not be reflected in the average. Thus, overcharging/overdischarging can be prevented also in these cases.

Further, as also discussed similarly elsewhere in this document, the minimum battery cell SoC and the maximum battery cell SoC may be determined using at least one of a Kalman filter and/or Coulomb counting.

Further, as discussed similarly elsewhere in this document, the weights in any method according to the present invention may be obtained using a look up table or may be obtained using a function, wherein the former version may lead to an overall simple implementation.

Moreover, as discussed at various points in this document, the weights may be normalized such that sum of the weights is equal to 1.

Figure 4 shows a schematic view of a module according to an embodiment of the present invention. This module 200 comprises a processor 201, a memory 202 and an input/output interface 203. The module 200 is configured to perform methods for estimating a battery state of charge according to embodiments of the present invention. The processor 201 is configured to process information/data provided. The memory 202 is configured to store and provide information. The input/output interface 203 is configured to receive information/data from an external source that is then provided to the processor 201 and/or the memory 202 and to provide information/data obtained from the processor 201 and/or the memory 202 to an external source.

Further, the module 200 may be part of a computer or may be a computer and accordingly the methods discussed herein can be understood as computer-implemented methods. Moreover, the module 200 may be part of an embedded system using the battery 100, for example the module 200 may be part of an electric vehicle being driven using the battery 100.

Moreover, the module 200 may also be part of a stationary energy storage system comprising the battery 100, for example in the context of charging an electric vehicle. Thus, an embodiment according to the present invention relates to an energy storage system comprising a module 200 according to an embodiment of the present invention as well as the battery 100 whose state of charge is estimated.

Accordingly, the module 200 may be a module for estimating a battery state of charge, SoC, of a battery comprising a plurality of battery cells, the module being configured to perform the steps of: determining a battery cell SoC for each of the plurality of battery cells; determining the battery SoC using a weighted sum of the plurality of battery cell SoC, wherein the weight corresponding to each battery cell SoC is determined based on at least a temperature of the battery cell and a SoC of the battery cell.

Further, the module 200 may be a module for estimating a battery state of charge, SoC, of a battery comprising a plurality of battery cells, the module being configured to perform the steps of: determining a minimum battery cell SoC and a maximum battery cell SoC among the plurality of battery cells; determining the battery SoC using a weighted sum of the minimum battery cell SoC and the maximum battery cell SoC.

Although detailed embodiments have been described, these only serve to provide a better understanding of the invention defined by the independent claims and are not to be seen as limiting to the present invention.

## Claims

1. A method for estimating a battery state of charge, SoC, of a battery comprising a plurality of battery cells, the method comprising the steps of:

   determining a battery cell SoC for each of the plurality of battery cells; and
   determining the battery SoC using a weighted sum of the plurality of battery cell SoC, wherein
   the weight corresponding to each battery cell SoC is determined based on at least a temperature of the battery cell and a SoC of the battery cell.

2. The method according to claim 1, wherein
   the weight corresponding to each battery cell SoC is determined based on at least one of a temperature of the battery cell, a SoC of the battery cell and/or an age of the battery cell.

3. The method according to claim 1 or 2, wherein
   the temperature of each battery cell is obtained based on calculations of the battery temperature distribution taking into account the spatial arrangement of the battery cells within the battery.

4. The method according to claim 3, wherein
   the calculations of the battery temperature distribution are performed in advance.

5. The method according to any one of claims 1 to 4, wherein
   the weight corresponding to each battery cell is positively correlated to the temperature of the battery cell and/or to the SoC of the battery cell.

6. The method according to any one of claims 1 to 5, wherein
the battery cell SoC for each of the plurality of battery cells is determined using at least one of a Kalman filter and/or Coulomb counting.

7. A method for estimating a battery state of charge, SoC, of a battery comprising a plurality of battery cells, the method comprising the steps of:

   determining a minimum battery cell SoC and a maximum battery cell SoC among the plurality of battery cells; and
   determining the battery SoC using a weighted sum of the minimum battery cell SoC and the maximum battery cell SoC.

8. The method according to claim 7, wherein

   the weight of the minimum battery cell SoC is correlated to a difference between the minimum battery cell SoC and a lower limit of the battery cell SoC, and
   the weight of the maximum battery cell SoC is correlated to a difference between the maximum battery cell SoC and an upper limit of the battery cell SoC.

9. The method according to claim 7 or 8, wherein
the minimum battery cell SoC and the maximum battery cell SoC are determined using at least one of a Kalman filter and/or Coulomb counting.

10. The method according to any one of claims 1 to 9, wherein
the weights are obtained using a look up table.

11. The method according to any one of claims 1 to 9, wherein
the weights are obtained using a function.

12. The method according to any one of claims 1 to 11, wherein
the weights are normalized such that sum of the weights is equal to 1.

13. A module for estimating a battery state of charge, SoC, of a battery comprising a plurality of battery cells, the module being configured to perform the steps of:

   determining a battery cell SoC for each of the plurality of battery cells; and
   determining the battery SoC using a weighted sum of the plurality of battery cell SoC, wherein
   the weight corresponding to each battery cell SoC is determined based on at least a temperature of the battery cell and a SoC of the battery cell.

14. A module for estimating a battery state of charge, SoC, of a battery comprising a plurality of battery cells, the module being configured to perform the steps of:

   determining a minimum battery cell SoC and a maximum battery cell SoC among the plurality of battery cells; and
   determining the battery SoC using a weighted sum of the minimum battery cell SoC and the maximum battery cell SoC

15. A system comprising the module according to claim 13 or 14 and the battery.

100

102

101

FIG. 1

| Determining cell state of charge | S10 |
| Determining battery state of charge | S20 |

FIG. 2

Determining minimum cell state of charge and maximum cell state of charge — S40

Determining battery state of charge — S50

FIG. 3

Module 200

Processor 201

Memory 202

I/O Interface 203

FIG. 4

Europäisches
Patentamt

European
Patent Office

Office européen
des brevets

# EUROPEAN SEARCH REPORT

Application Number

EP 23 15 3044

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | US 2014/324370 A1 (UNDERHILL TYLER [US] ET AL) 30 October 2014 (2014-10-30)<br>* paragraphs [0008] – [0052]; claims 1-20; figures 1-3 * | 1,2,5,6,<br>10-13,15<br>3,4 | INV.<br>G01R31/367<br>G01R31/396<br>H02J7/00 |
| X<br>A | WO 2022/024836 A1 (PANASONIC IP MAN CO LTD [JP]) 3 February 2022 (2022-02-03)<br>* paragraphs [0013] – [0093]; claims 1-9; figures 1-8 * | 1,2,5,6,<br>10-13,15<br>3,4 | |
| X<br><br><br><br><br><br><br><br>A | NAGUIB MINA ET AL: "Lithium-Ion Battery Pack Robust State of Charge Estimation, Cell Inconsistency, and Balancing: Review",<br>IEEE ACCESS, IEEE, USA,<br>vol. 9, 24 March 2021 (2021-03-24), pages 50570-50582, XP011848281,<br>DOI: 10.1109/ACCESS.2021.3068776<br>* page 50574 – page 50577; figures 8-13 * | 1,2,5,6,<br>10-13,15<br><br><br><br><br><br><br>3,4 | |
| | | | TECHNICAL FIELDS SEARCHED (IPC)<br><br>G01R<br>H02J<br>H01M |

The present search report has been drawn up for all claims

| Place of search | Date of completion of the search | Examiner |
|---|---|---|
| The Hague | 22 June 2023 | Bilzer, Claus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
............................................................
& : member of the same patent family, corresponding document

EPO FORM 1503 03.82 (P04C01)

Europäisches
Patentamt

European
Patent Office

Office européen
des brevets

**Application Number**

**EP 23 15 3044**

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

    see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☐ Only part of the further search fees have been paid within the fixed time limit. The present European search report has been drawn up for those parts of the European patent application which relate to the inventions in respect of which search fees have been paid, namely claims:

☒ None of the further search fees have been paid within the fixed time limit. The present European search report has been drawn up for those parts of the European patent application which relate to the invention first mentioned in the claims, namely claims:

    1-6, 10-13, 15

☐ The present supplementary European search report has been drawn up for those parts of the European patent application which relate to the invention first mentioned in the claims (Rule 164 (1) EPC).

**Europäisches Patentamt**
**European Patent Office**
**Office européen des brevets**

## LACK OF UNITY OF INVENTION
## SHEET B

Application Number

EP 23 15 3044

The Search Division considers that the present European patent application does not comply with the requirements of unity of invention and relates to several inventions or groups of inventions, namely:

```
1. claims: 1-6, 10-13, 15

        Estimating a battery SoC taking into account all individual
        cell SoCs with weights dependent at least on cell
        temperature/cell SoC.
                        ---

2. claims: 7-12, 14, 15

        Estimating a battery SoC based on a weighted sum of a
        minimum cell SoC and a maximum cell SoC without any specific
        choice of weights.
                        ---
```

## ANNEX TO THE EUROPEAN SEARCH REPORT
## ON EUROPEAN PATENT APPLICATION NO.

EP 23 15 3044

This annex lists the patent family members relating to the patent documents cited in the above-mentioned European search report.
The members are as contained in the European Patent Office EDP file on
The European Patent Office is in no way liable for these particulars which are merely given for the purpose of information.

22-06-2023

| Patent document cited in search report | | Publication date | Patent family member(s) | | Publication date |
|---|---|---|---|---|---|
| US 2014324370 | A1 | 30-10-2014 | AU | 2014260382 A1 | 12-11-2015 |
| | | | CA | 2911026 A1 | 06-11-2014 |
| | | | EP | 2991852 A2 | 09-03-2016 |
| | | | JP | 6333960 B2 | 30-05-2018 |
| | | | JP | 6653347 B2 | 26-02-2020 |
| | | | JP | 2016528662 A | 15-09-2016 |
| | | | JP | 2018160459 A | 11-10-2018 |
| | | | KR | 20160003817 A | 11-01-2016 |
| | | | US | 2014324370 A1 | 30-10-2014 |
| | | | WO | 2014178994 A2 | 06-11-2014 |
| WO 2022024836 | A1 | 03-02-2022 | CN | 116195111 A | 30-05-2023 |
| | | | EP | 4191741 A1 | 07-06-2023 |
| | | | JP | WO2022024836 A1 | 03-02-2022 |
| | | | US | 2023307925 A1 | 28-09-2023 |
| | | | WO | 2022024836 A1 | 03-02-2022 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- PDE model for thermal dynamics of a large Li-ion battery pack. **ANDREY et al.** Proceedings of the 2011 American Control Conference. IEEE, 2011